# EUROPÄISCHE PATENTSCHRIFT

(11) **EP 0 404 996 B1**
(45) Veröffentlichungstag und Bekanntmachung des Hinweises auf die Patenterteilung: **01.06.1994**
(21) Anmeldenummer: 89111982.8
(22) Anmeldetag: 30.06.1989
(51) Int. Cl.: H02M 3/335, H02M 3/337, H03K 17/16

(54) **Umrichter mit Stromistwertbildung**
Converter presenting an actual current value
Convertisseur avec formation de la valeur du courant effectif

(43) Veröffentlichungstag der Anmeldung: 02.01.1991
(73) Patentinhaber: SIEMENS AKTIENGESELLSCHAFT, 80333 München (DE)
(72) Erfinder: Niederreiter, Hans, Dipl-Ing., D-8000 Müchen 71 (DE)

(56) Entgegenhaltungen:
- US-A- 3 875 516
- PATENT ABSTRACTS OF JAPAN vol. 8, no. 135 (E-252)(1572) 22 Juni 1984, & JP-A-59 44973 (HITACHI) 13 März 1984.
- PATENT ABSTRACTS OF JAPAN vol. 6, no. 28 (E-95)(906) 19 Februar 1982, & JP-A-56 148178 (HITACHI) 17 November 1981.

## Beschreibung

Die Erfindung bezieht sich auf einen wie im Oberbegriff des Patentanspruchs 1 angegebenen Umrichter mit einer Schaltungsanordnung zur Stromistwertbildung.

Ein derartiger Umrichter ist bereits aus der DE-B1-28 38 009 bekannt. Bei dem bekannten Umrichter wird ein Schalttransistor durch einen Taktgeber mit Einschaltimpulsen konstanter Arbeitsfrequenz angesteuert. Zur Regelung der Ausgangsspannung wird der Tastgrad, d.h. der Quotient der Einschaltzeit des Leistungsschalttransistors zur Periodendauer verändert. Bei Überlast am Ausgang des Gleichstromumrichters wird zum Schutz der Bauteile der Strom im Leistungskreis begrenzt. Dies wird durch Absenken der Ausgangsspannung bei zulässigem Ausgangsstrom mittels Verkürzung der Einschaltzeit erreicht. Dabei wird der Schalttransistor gesperrt, sobald der gemessene Momentanwert des durch den Schalttransistor fließenden Stromes einen vorgegebenen Grenzwert übersteigt.

Der bekannte Umrichter enthält zu diesem Zweck eine Strombegrenzungsschaltung mit einem Stromwandler als Stromsensor. Diesem Stromsensor ist ein RC-Filter als Tiefpaß nachgeschaltet, so daß die Bürdenspannung von Einschaltstromspitzen befreit wird. Auf diese Weise wird vermieden, daß die Sperrung des Schalttransistors fälschlicherweise vorzeitig durch die Einschaltstromspitze ausgelöst wird.

Allerdings kann das RC-Glied nur für einen bestimmten Strom optimal dimensioniert werden. Die Verwendung eines derartigen Tiefpasses führt daher nur bei vergleichsweise kleinen Strombereichen zum gewünschten Ergebnis.

Aus den Patent Abstracts of Japan, Vol. 8, No. 135 (E-252) (1572) 22. Juni 1984 & JP-A-59 44973 (Hitachi) 13. März 1984 ist bereits ein schaltender Umrichter bekannt, bei dem im primärseitigen Hauptstromkreis ein elektronischer Schalter angeordnet ist. Der schaltende Umrichter enthält eine Schaltungsanordnung zur Stromistwertbildung mit einem in Serie zum elektronischen Schalter angeordneten, von rampenförmigen Stromimpulsen durchflossenen Stromsensor. Der elektronische Schalter ist an eine Steuerschaltung angeschlossen, die den elektronischen Schalter in Abhängigkeit vom Stromistwert steuert. Der Umrichter enthält eine Anordnung zur Feststellung von Überströmen, die Änderungen des im eingangsseitigen Hauptstromkreis fließenden Stromes identifiziert und so Überströme festsstellt. Um Überströme von Störspannungsspitzen zu unterscheiden, ist ein Zeitentscheider vorgesehen, der dafür sorgt, daß ein Störstrom von kurzer Dauer und großer Amplitude nicht als Überstrom gilt. Auf diese Weise wird nur der Impulsstrom berücksichtigt, der eine vorgegebene Impulsdauer überschreitet. Zur Unterscheidung von Störimpulsen und Überströmen ist ferner eine Zeit- bzw. Verzögerungsschaltung erforderlich. Eine Ausblendung von Einschaltstromspitzen mit Hilfe eines zusätzlichen elektronischen Schalters ist dabei nicht vorgesehen.

Aufgabe der Erfindung ist es, die Schaltungsanordnung zur Stromistwertbildung eines Umrichters der eingangs genannten Art derart auszubilden, daß Einschaltstromspitzen der den Stromsensor durchfließenden Stromimpulse bei der Stromistwertbildung innerhalb eines möglichst großen Strombereiches unterdrückt werden.

Es ist eine Erkenntnis im Rahmen der Erfindung, daß bei schaltenden Umrichtern der eingangs genannten Art die Dauer der Anfangsstromspitze praktisch unabhängig von der Strombelastung des Umrichters ist.

Ausgehend von dieser Erkenntnis wird der Umrichter gemäß der Erfindung zur Lösung der genannten Aufgabe in der im kennzeichnenden Teil des Patentanspruchs 1 angegebenen Weise ausgebildet. Durch die erfindungsgemäßen Maßnahmen ergibt sich in vorteilhafter Weise eine exakte Strombegrenzung in einem besonders großen Lastbereich. Dies ist von besonderem Vorteil, wenn ein Strom innerhalb eines großen Arbeitsbereiches geregelt werden soll oder wenn eine Strombegrenzung in einem weiten Bereich einstellbar sein soll.

Durch die Maßnahmen nach Anspruch 2 ergibt sich in vorteilhafter Weise, daß die Gate-Source-Kapazität eines als elektronischer Schalter dienenden Feldeffekttransistors Bestandteil des Verzögerungsgliedes ist.

Nach Anspruch 3 kann diese Kapazität durch einen zusätzlichen Kondensator so ergänzt werden, daß sich eine optimale Verzögerung ergibt.

Ein besonders geringer Einfluß der Steuerimpulse auf den Strommeßwert ergibt sich durch die Bemessung nach Anspruch 4.

Durch die Maßnahmen nach Anspruch 5 wird eine zweckmäßige Anbindung der Source-Elektrode des in der Schaltungsanordnung zur Stromistwertbildung enthaltenenen Feldeffekttransistors an die Source-Elektrode des im Hauptstromkreis angeordneten Feldeffekttransistors erreicht.

Eine vorteilhafte Ausbildung des Umrichters als Gegentaktschaltung geht aus Anspruch 6 hervor.

Ein besonders geringer Einfluß der Kapazität des elektronischen Schalters der Schaltungsanordnung zur Stromistwertbildung auf den Strommeßwert ergibt sich durch die Maßnahmen nach Anspruch 7. Dabei wird die Kapazität insbesondere so klein bemessen, daß das RC-Glied, gebildet durch den Widerstand des geschlossenen elektronischen Schalters und den Kondensator einen vernachlässigbaren Einfluß auf die Ausgangsspannung der Schaltungsanordnung zur Stromistwertbildung hat.

Die Erfindung wird anhand der in den Figuren 1 und 2 dargestellten Ausführungsbeispiele sowie anhand der aus den Figuren 3 bis 5 ersichtlichen Diagramme näher erläutert.

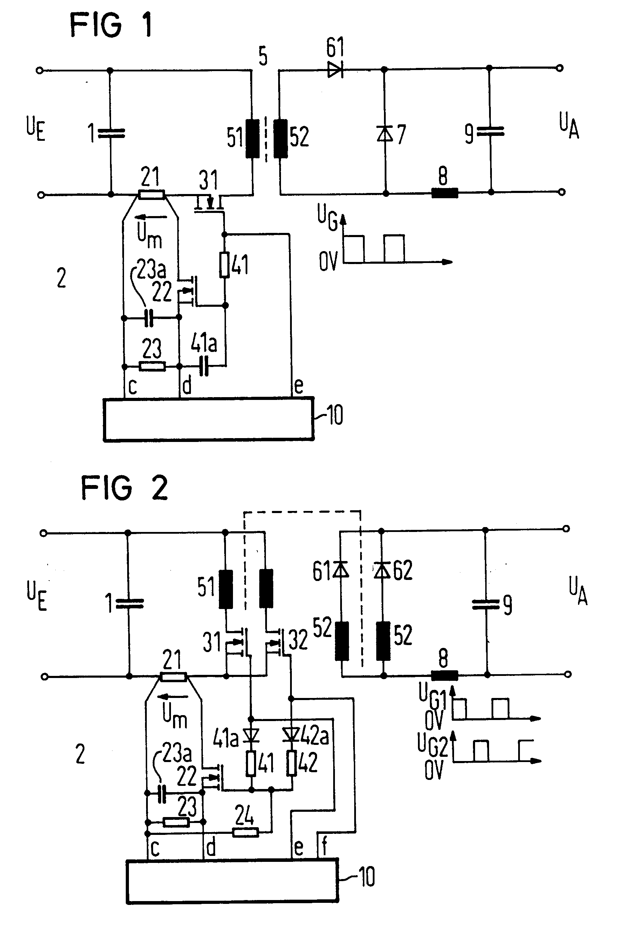

Es zeigen
- Fig. 1: einen Umrichter in Eintaktschaltung mit einer Schaltungsanordnung zur Stromistwertbildung,
- Fig. 2: einen Umrichter in Gegentaktschaltung mit einer Schaltungsanordnung zur Strom-Istwertbildung,

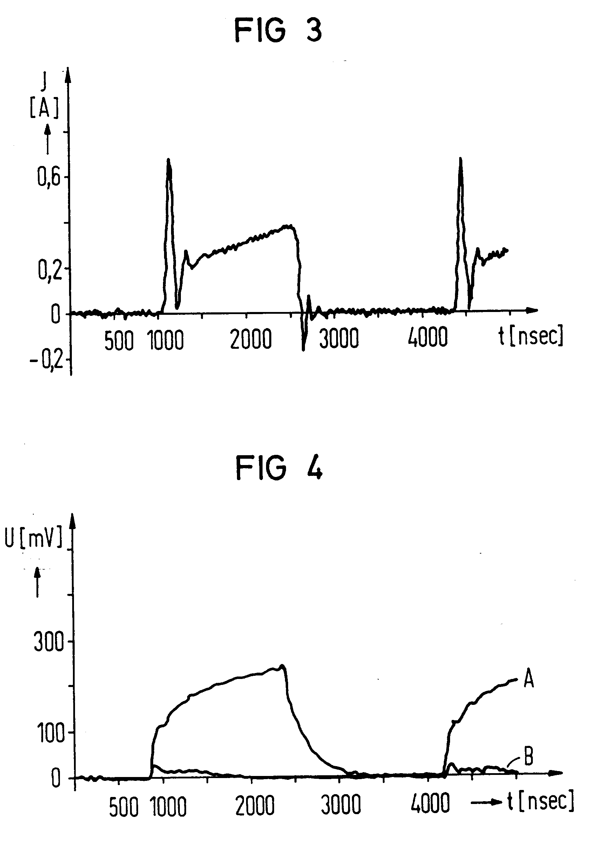

- Fig. 3: den zeitlichen Verlauf eines Stromimpulses mit überlagerter Einschaltstromspitze,
- Fig. 4: den zeitlichen Verlauf einer Meßspannung bei herkömmlicher Tiefpaßfilterung bei unterschiedlich großem Strom,

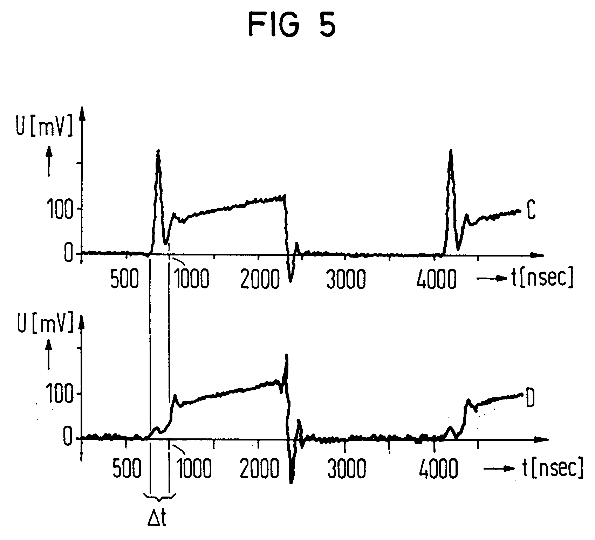

- Fig. 5: ein Meßsignal am Stromsensor und ein Meßsignal am Ausgang der Schaltungsanordnung zur Stromistwertbildung im Vergleich.

Bei dem in Fig. 1 gezeigten Eintakt-Durchflußumrichter liegt die Eingangsspannung U_{E} am Kondensator 1 und die Ausgangsspannung U_{A} am Kondensator 9. Parallel zum Kondensator 1 liegt eine aus der Primärwicklung 51 des Transformators 5, der Source-Drain-Strecke des Feldeffekttransistors 31 und dem Meßwiderstand 21 gebildete Serienschaltung. Zwischen der Sekundärwicklung 52 des Transformators 5 und dem Kondensator 9 liegt die Gleichrichterdiode 61. In einem auf die Gleichrichterdiode 61 folgenden Querzweig ist die Freilaufdiode 7 angeordnet. In einem Längszweig zwischen Freilaufdiode 7 und Kondensator 9 liegt die Drossel 8. Anstelle des Meßwiderstandes 21 kann als Stromsensor ggf. ein Stromwandler Verwendung finden.

Die Steuerelektrode des Feldeffekttransistors 31 ist an den Ausgang e der Steuerschaltung 10 angeschlossen. Der Meßwerteingang c,d der Steuerschaltung 10 liegt am Ausgang der Schaltungsanordnung 2 zur Stromistwertbildung. Der mit dem Feldeffekttransistor 31 unmittelbar verbundene Anschluß des Stromsensors 21 ist über die Drain-Source-Strecke des Feldeffekttransistors 22 an den Anschluß d des Istwert-Einganges der Steuerschaltung 10 geführt. Der andere Anschluß des Stromsensors 21 ist unmittelbar mit dem Anschluß c verbunden. Parallel zum Eingang c,d liegt die aus dem Widerstand 23 und dem Kondensator 23a bestehende Parallelschaltung. Der Kondensator 23a kann entfallen, wenn der Einfluß der wirksamen Drain-Source-Kapazität des Feldeffekttransistors 22 vernachlässigbar klein ist.

Die Steuerelektrode des Feldeffekttransistors 22 ist über den Widerstand 41 an die Steuerelektrode 31 des Feldeffekttransistors 31 angeschlossen. Parallel zur Gate-Source-Strecke des Feldeffekttransistors 22 liegt der Kondensator 41a.

Bei dem Eintakt-Durchflußumrichter nach Fig. 1 steigt der Strom im Primärkreis während der Einschaltdauer des durch den Feldeffekttransistor 31 gebildeten primären Leistungshalbleiters rampenförmig an. Dieser Strom wird mittels des durch den Widerstand 21 gebildeten Shunts in die Spannung U_{M} umgesetzt und in der Steuerschaltung 10 als Stromistwert zur Strombegrenzung und/oder Current-Mode-Regelung benutzt. Durch Kapazitäten und Sperrverzögerung anderer beteiligter Leistungshalbleiter auf der Primär- und/oder Sekundärseite des Umrichters ist dem Stromimpuls eine unvermeidliche Einschaltstromspitze überlagert, wie sie in Fig. 3 beispielhaft gezeigt ist. Diese Einschaltstromspitze würde bei der Weiterverarbeitung des Meßsignals erheblich stören. Mit Hilfe der in Fig. 1 gezeigten Schaltungsanordnung wird sie unterdrückt, ohne den weiteren Verlauf des Signals wesentlich zu verändern.

Bei vergleichbaren Umrichtern bekannter Art wird die Einschaltstromspitze mit Hilfe eines Tiefpasses bzw. RC-Filters unterdrückt. Dies führt, wie aus einem Vergleich von Fig. 4, Kurve A für einen großen Strom und B für einen kleinen Strom ergibt, bei größeren Strombereichen zu erheblichen Verfälschungen des Meßsignals, da das RC-Glied nur für einen bestimmten Strom optimal dimensioniert werden kann.

Bei dem Umrichter nach Fig. 1 wird das Meßsignal während der Dauer der Anfangsstromspitze mittels einer Schalteinrichtung von der Steuerschaltung 10 abgetrennt. Während der restlichen Zeit der Stromflußdauer ist das Signal dagegen voll durchgeschaltet und damit praktisch unverfälscht. Fig. 5, Kurve c zeigt ein Meßsignal vor, D ein Meßsignal nach der Schalteinrichtung.

Nach Fig. 1 dient als Schalteinrichtung, die das Meßsignal während der Einschaltstromspitze von der Steuerschaltung 10 fernhält, ein elektronischer Schalter, der mit dem Einschaltsignal des Leistungsschalters im Primärkreis, aber um die Zeit Δ t verzögert, durchgeschaltet wird.

Der elektronische Schalter ist ein MOS-Feldeffekttransistor 22, der mit der Gatespannung U_{G} des Leistungstransistors 31 über den Widerstand 41 angesteuert wird. Die Zeitverzögerung ergibt sich aus dem Widerstand 41 und der Kapazität, die die Parallelschaltung aus Gate-Kapazität des Feldeffekttransistors und Kondensator 41a hat.

Gegebenenfalls kann der Kondensator 41a entfallen, so daß im Verzögerungsglied als Kapazität nur die Gate-Kapazität des Feldeffekttransistors 22 wirksam ist.

Der Widerstand 23 ist niederohmig gegenüber dem Widerstand 41 und dient der potentialmäßigen Anbindung der Source des Feldeffekttransistors 22 an die Source des Feldeffekttransistors 31. Um das Meßsignal Uₘ nicht wesentlich zu verfälschen, ist der Widerstand 23 zweckmäßigerweise hochohmig gegenüber dem Wert R_{DS} des Feldeffekttransistors 22.

In Fig. 2 ist ein Durchflußumrichter in Gegentaktschaltung dargestellt, bei dem der Feldeffekttransistor 22, der das Meßsignal zur Steuerschaltung 10 durchschaltet oder die Einschaltstromspitze von der Steuerschaltung 10 fernhält, durch die Einschaltsignale der beiden Leistungsschalter des Gegentaktumrichters gesteuert wird.

Dieser Gegentaktumrichter unterscheidet sich von dem Eintaktumrichter nach Fig. 1 dadurch, daß parallel zu dem aus Primärwicklung 51 und Drain-Source-Strecke des Feldeffekttransistors 31 bestehenden Serienschaltung eine weitere Serienschaltung angeordnet ist, die aus der weiteren Primärwicklung 53 des Transformators 5 und dem weiteren Feldeffekttransistor 32 besteht. Außerdem ist parallel zu der aus Sekundärwicklung 52 und Gleichrichterdiode 61 bestehenden Serienschaltung die weitere, aus der weiteren Sekundärwicklung 54 und der weiteren Gleichrichterdiode 62 bestehende Serienschaltung angeordnet. Ein weiterer Unterschied besteht darin, daß der Gegentaktumrichter keine Freilaufdiode enthalten muß.

Die Schaltungsanordnung 2 zur Strom-Istwertbildung nach Fig. 2 unterscheidet sich von der nach Fig. 1 lediglich dadurch, daß die Steuerelektrode des Feldeffekttransistors 22 über den zusätzlichen Widerstand 42 und die dazu in Serie liegende Diode 42a an die Steuerelektrode des zusätzlichen Feldeffekttransistors 32 angeschlossen ist, der an den weiteren Steuerausgang f der Steuerschaltung 10 angeschlossen ist und daß in Serie zum Widerstand 41 die Diode 41a liegt und daß die Steuerelektrode des Feldeffekttransistors 22 über den Widerstand 24 an einen der Ausgangsanschlüsse der Schaltungsanordnung 2 geführt ist. Die Dioden 41a und 42a können durch Verbindungen ersetzt und der Widerstand 24 weggelassen werden, wenn als Steuerspannung für den Feldeffekttransistor 22 die Hälfte der Steuerspannung der Feldeffekttransistoren 31 und 32 ausreicht. Ebenso wie nach Fig. 1 kann parallel zur Gate-Source-Strecke des Feldeffekttransistors 22 ein Kondensator 41a angeordnet werden.

In den Figuren 1 und 2 sind jeweils Gleichstromumrichter gezeigt. Die beschriebene Unterdrückung der Anfangsstromspitze kann jedoch in entsprechender Weise bei anderen getakteten Stromversorgungsgeräten, insbesondere bei Sperrumrichtern Verwendung finden.

## Patentansprüche

1. Schaltender Umrichter mit einer Schaltungsanordnung zur Stromistwertbildung, mit einem in einem Hauptstromkreis des Umrichters angeordneten elektronischen Schalter (31, 32) und mit einem in Serie zum elektronischen Schalter (31, 32) angeordneten, von rampenförmigen Stromimpulsen durchflossenen Stromsensor (21), wobei der elektronische Schalter (31, 32) mit seinem Steuereingang an einen Steuerausgang (e) einer Steuerschaltung (10) angeschlossen ist, die mit einem Eingang (c, d) am Ausgang der Schaltungsanordnung zur Stromistwertbildung liegt und die Folgefrequenz und/oder das Tastverhältnis der an ihrem Steuerausgang (e) abgegebenen Steuerimpulse in Abhängigkeit vom Stromistwert dadurch steuert, daß der zeitlich ansteigende Momentanwert des rampenförmigen Stromimpulses mit einem Referenzwert verglichen wird,
**dadurch gekennzeichnet,**
daß die Schaltungsanordnung (2) zur Stromistwertbildung einen zwischen dem Stromsensor (21) und ihrem Ausgang (c, d) angeordneten elektronischen Schalter (22) enthält, und daß der elektronische Schalter (22) der Schaltungsanordnung zur Stromistwertbildung derart steuerbar ist, daß er je Einschaltphase des im Hauptstromkreis angeordneten elektronischen Schalters (31) während der Anfangsstromspitze des den Stromsensor (21) durchfließenden Stromes gesperrt und während der restlichen Zeit des Stromimpulses leitend gesteuert ist und
daß zwischen dem Steuereingang des elektronischen Schalters (22) der Schaltungsanordnung (2) zur Stromistwertbildung und dem Ausgang der Steuerschaltung (10) ein Verzögerungsglied (41, 41a) vorgesehen ist.

2. Umrichter nach Anspruch 1,
**dadurch gekennzeichnet,**
daß bei Ausbildung des im Hauptstromkreis angeordneten elektronischen Schalters (31) als Feldeffekttransistor (31) das Verzögerungsglied (10) aus einem der Steuerelektrode des Feldeffekttransistors (31) vorgeschalteten ohmschen Widerstand (41) und der Gate-Source-Kapazität des Feldeffekttransistors (31) besteht.

3. Umrichter nach Anspruch 1,
**dadurch gekennzeichnet,**
daß bei Ausbildung des im Hauptstromkreis angeordneten elektronischen Schalters (31) als Feldeffekttransistor (31) das Verzögerungsglied (10) aus einem der Steuerelektrode des Feldeffekttransistors (31) vorgeschalteten ohmschen Widerstand (41) und der Gate-Source-Kapazität des Feldeffekttransistors (31) und einem dazu parallel angeordneten Kondensator (41a) besteht.

4. Umrichter nach Anspruch 2 oder 3,
**dadurch gekennzeichnet,**
daß am Ausgang der Schaltungsanordnung (2) zur Stromistwertbildung ein gegenüber dem Widerstand (41) des Verzögerungsgliedes niederohmiger Widerstand (23) angeordnet ist.

5. Umrichter nach Anspruch 4,
**dadurch gekennzeichnet,**
daß der weitere Widerstand (23) hochohmig gegenüber dem Widerstand des leitend gesteuerten elektronischen Schalters (22) der Schaltungsanordnung (2) zur Stromistwertbildung ist.

6. Umrichter nach einem der Ansprüche 1 bis 5,
**dadurch gekennzeichnet,**
daß bei Ausbildung des Umrichters als Gegentaktschaltung der im Hauptstromkreis angeordnete elektronische Schalter (31) zusammen mit einem weiteren, in einem weiteren Zweig des Hauptstromkreises liegenden elektronischen Schalter (32) mit dem Stromsensor (21) verbunden ist und daß die Steuereingänge der beiden elektronischen Schalter (31, 32) des Hauptstromkreises über je ein Verzögerungsglied (41, 42) an den Steuereingang des elektronischen Schalters (22) der Schaltungsanordnung (2) zur Stromistwertbildung geführt sind.

7. Umrichter nach einem der Ansprüche 1 bis 6,
**dadurch gekennzeichnet,**
daß parallel zum Ausgang der Schaltungsanordnung (2) zur Stromistwertbildung ein Kondensator (23a) angeordnet ist.

## Claims

1. Switching converter having a circuit arrangement for the formation of the actual current value, having an electronic switch (31, 32) arranged in a main circuit of the converter and having a current sensor (21) which is arranged in series with the electronic switch (31, 32) and through which ramp-shaped current pulses flow, in which the electronic switch (31, 32) is connected by its control input to a control output (e) of a control circuit (10) which is connected by one input (c, d) to the output of the circuit arrangement for the formation of the actual current value and controls the repetition rate and/or the pulse duty factor of the control pulses output at its control output (e) depending on the actual current value in such a way that the temporally rising momentary value of the ramp-shaped current pulse is compared with a reference value, characterized in that the circuit arrangement (2) for the formation of the actual current value contains an electronic switch (22) arranged between the current sensor (21) and its output (c, d), and in that the electronic switch (22) of the circuit arrangement for the formation of the actual current value can be controlled in such a way that, for each turn-on phase of the electronic switch (31) arranged in the main circuit, it is inhibited during the initial current peak of the current flowing through the current sensor (21) and is conductive during the remaining time of the current pulse, and in that a delay element (41, 41a) is provided between the control input of the electronic switch (22) of the circuit arrangement (2) for the formation of the actual current value and the output of the control circuit (10).

2. Converter according to Claim 1, characterized in that when the electronic switch (31) arranged in the main circuit is designed as a field-effect transistor (31), the delay element (10) comprises an ohmic resistor (41) connected upstream of the control electrode of the field-effect transistor (31) and the gate-source capacitance of the field-effect transistor (31).

3. Converter according to Claim 1, characterized in that when the electronic switch (31) arranged in the main circuit is designed as a field-effect transistor (31), the delay element (10) comprises an ohmic resistor (41) connected upstream of the control electrode of the field-effect transistor (31) and the gate-source capacitance of the field-effect transistor (31) and a capacitor (41a) arranged parallel thereto.

4. Converter according to Claim 2 or 3, characterized in that a resistor (23) having a low impedance in relation to the resistor (41) of the delay element is arranged at the output of the circuit arrangement (2) for the formation of the actual current value.

5. Converter according to Claim 4, characterized in that the further resistor (23) has a high impedance in relation to the resistance of the conductive electronic switch (22) of the circuit arrangement (2) for the formation of the actual current value.

6. Converter according to one of Claims 1 to 5, characterized in that when the converter is designed as a push-pull circuit, the electronic switch (31) arranged in the main circuit is connected together with a further electronic switch (32) situated in a further branch of the main circuit to the current sensor (21), and in that the control inputs of the two electronic switches (31, 32) of the main circuit are connected in each case via a delay element (41, 42) to the control input of the electronic switch (22) of the circuit arrangement (2) for the formation of the actual current value.

7. Converter according to one of Claims 1 to 6, characterized in that a capacitor (23a) is arranged parallel to the output of the circuit arrangement (2) for the formation of the actual current value.

## Revendications

1. Convertisseur à commutation comportant un montage qui sert à la formation de la valeur instantanée du courant, qui comporte un commutateur électronique (31, 32) monté dans le circuit électrique principal du convertisseur et un détecteur de courant (21) monté en série avec le commutateur électronique (31, 32) et parcouru par des impulsions de courant en forme de rampe, le commutateur électronique (31, 32) étant relié, par son entrée de commande, à l'entrée de commande (e) d'un circuit de commande (10), qui est relié, par une entrée (c, d), à la sortie du montage de formation de la valeur instantanée du courant et qui commande la fréquence de récurence et/ou le taux d'impulsions de commande fournies à son entrée de commande (e), en fonction de la valeur instantanée du courant, par le fait que la valeur instantanée, qui augmente temporellement, de l'impulsion du courant en forme de rampe est comparée à une valeur de référence, caractérisé en ce que le montage (2) de formation de la valeur instantanée du courant comporte un commutateur électronique (22) monté entre le détecteur de courant (21) et sa sortie (c, d), et que le commutateur électronique (22) du montage de formation de la valeur instantanée du courant est susceptible d'être commandé de telle sorte qu'il est bloqué pour chaque phase de branchement du commutateur électronique (31) monté dans le circuit électrique principal, pendant les pointes de courant de démarrage passant dans le détecteur de courant (21) et qu'il est commandé à l'état passant pendant le reste du temps de l'impulsion de courant, et qu'il est prévu un circuit à retard (41, 41a) entre l'entrée de commande du commutateur électronique (22) du montage (2) de formation de la valeur instantanée du courant et la sortie du circuit de commande (10).

2. Convertisseur suivant la revendication 1,
caractérisé en ce que pour la formation, en tant que transistor à effet de champ (31), du commutateur électronique (31) monté dans le circuit électrique principal, le circuit à retard (10) est constitué d'une résistance ohmique (41) montée en amont de l'électrode de commande du transistor à effet de champ (31), et de la capacité grille-source du transistor à effet de champ (31).

3. Convertisseur suivant la revendication 1,
caractérisé en ce que, pour la formation, en tant que transistor à effet de champ (31), du commutateur électronique (31) monté dans le circuit électrique principal, le circuit à retard (10) est constitué d'une résistance ohmique (41) montée en amont de l'électrode de commande du transistor à effet de champ (31), de la capacité grille-source du transistor à effet de champ (31) et d'un condensateur (41a) monté en parallèle.

4. Convertisseur suivant la revendication 2 ou 3,
caractérisé en ce qu'une résistance (23) de faible valeur ohmique par rapport à la résistance (41) du circuit à retard, est montée à la sortie du montage (2) de formation de la valeur instantanée du courant.

5. Convertisseur suivant la revendication 4,
caractérisé en ce que l'autre résistance (23) est de faible valeur ohmique par rapport à la résistance du commutateur électronique (22), commandé à l'état passant, du montage (2) de formation de la valeur instantanée du courant.

6. Convertisseur suivant l'une des revendications 1 à 5,
caractérisé en ce que pour la formation du convertisseur en tant que circuit symétrique, le commutateur électronique (31) monté dans le circuit électrique principal est relié au détecteur de courant (21), conjointement avec un commutateur électronique (32) monté dans une autre branche du circuit électrique principal, et que les entrées de commande des deux commutateurs électroniques (31, 32) du circuit électrique principal sont reliées, par l'intermédiaire respectivement d'un circuit à retard (41, 42), à l'entrée de commande du commutateur électronique (22) du montage (2) de formation de la valeur instantanée du courant.

7. Convertisseur suivant l'une des revendications 1 à 6,
caractérisé en ce qu'un condensateur (23a) est monté en parallèle à la sortie du montage (2) de formation de la valeur instantanée du courant.
